# EUROPEAN PATENT APPLICATION

(11) **EP 2 059 109 A2**
(43) Date of publication of application: **13.05.2009**
(21) Application number: 08168428.4
(22) Date of filing: 05.11.2008
(51) Int. Cl.: H05K 9/00

(54) **Composite cover**

(30) Priority: 07.11.2007 US 986199 P; 02.04.2008 US 61481
(71) Applicant: Honeywell International Inc., Morristown, NJ 07962 (US)
(72) Inventor: Vacanti, David C., Morristown, NJ 07962-2245 (US); Stevenson, James, Morristown, NJ 07962-2245 (US)
(74) Representative: Buckley, Guy Julian

(57) **Abstract**

A composite cover (32,34) for dust, dirt and incidental moisture protection over an extended temperature range, EMI shielding to prevent radiation of internal circuit energy and preventing the entrance of external EMI. Also the cover provides mechanical strength and protection of circuitry and radiates heat created by internal circuitry. The cover provides lower levels of radiated emissions and improved resistance to incident external radiation. Electric and magnetic shielding is also provided.

## Description

### BACKGROUND OF THE INVENTION

Traditionally electromagnetic covers are made from multiple forms of aluminum that are attached to circuit boards that contain RF, microwave, millimeterwave, or high speed digital circuitry to prevent radiation into adjacent boards or modules and from radiating outside of the overall chassis.

Metal covers generally succeed very well in achieving high shielding effectiveness. However, each metal cover also internally creates one or more resonant cavities with relatively high Q (ratio of power stored to power dissipated) that are capable of supporting undesired transmission modes and/or causing circuits to become unstable and oscillate. Cavities with high Q easily store energy at a resonant frequency. Cavities with low Q dissipate resonant energy and suppress oscillations. Furthermore, any metal cover that is installed is capable of unintentionally radiating energy from within the cover if any unintended gaps between the cover and the circuit board ground are allowed to exist. The gaps become slot antennas capable of re-radiating energy within the cover, including unintended oscillations. This negates the shield feature of the metal cover.

When these circuit assemblies or modules with metal covers are then placed within a metal chassis, unintended radiation from covers on circuit boards and interconnect wiring establishes zones of strong electromagnetic fields that may interfere with other modules or radiate from the metal chassis at a gap or slot in the cover. Metal covers support the flow of electromagnetic current on the surface with relatively low loss that is available for re-radiation or coupling to internal circuits and wiring under the right conditions.

### SUMMARY OF THE INVENTION

The present invention provides a circuit board cover that provides dust, dirt and incidental moisture protection over an extended temperature range, EMI shielding to prevent radiation of internal circuit energy outside of the cover and prevents the entrance of external EMI. Also, the cover has mechanical strength for protection of circuitry and transfers heat created by internal circuitry. The present invention has lower cost and weight than typical machined metal covers, lower levels of radiated emissions and improved resistance to incident external radiation. The present invention may provide both electric and magnetic shielding.

In one aspect of the invention, the cover is made of a "low Q" lossy material that provides shielding and performs repeated absorption of reflected energy. Any energy that initially passes through the lossy cover is reflected back to the cover and is absorbed or dissipated at each subsequent reflection. The lossy cover effectively dissipates energy reaching its surface, thereby reducing cavity resonance and re-radiation from slot gaps.

An example lossy composite cover is not made to have the highest possible conductivity. A cover with the highest possible conductivity would approach conductivity achieved in metals such as aluminum. An example cover has a modest resistivity, for example 0.5 to 10 ohm-cm.

Injection molded composite covers with modest conductivity also offer the benefits of reduced weight and significantly reduced costs over machined metal covers and very high conductivity composite covers.

### BRIEF DESCRIPTION OF THE DRAWINGS

Preferred and alternative embodiments of the present invention are described in detail below with reference to the following drawings:

FIGURE 1 illustrates a perspective view of an electronics chassis for housing circuit board assemblies formed in accordance with an embodiment of the present invention;

FIGURES 2 & 3 illustrate cutaway views of the chassis shown in FIGURE 1;

FIGURE 4 illustrates a perspective view of a circuit board assembly with covers formed in accordance with an embodiment of the present invention;

FIGURE 5 illustrates a plan view of the assembly shown in FIGURE 4 with one of the covers removed;

FIGURE 6 illustrates a plan view of the assembly shown in FIGURE 4; and

FIGURE 7 illustrates a perspective view of an example composite cover formed in accordance with an alternate embodiment of the present invention.

### DETAILED DESCRIPTION OF THE PREFERRED EMBODIMENT

An (avionics) circuit board cover in one embodiment includes a plastic resin material capable of retaining full strength over expected operating and storage temperature ranges. The cover includes a polymeric resin combined with composite fill material(s) that in one embodiment meet Federal Aviation Administration (FAA) Flammability, Smoke Density and Toxicity (FST) requirements for commercial aircraft applications. For internally packaged circuit boards, the resistivity of the composite material is preferably less than 10 ohm-cm and greater than 0.5 ohm-cm.

Electromagnetic simulation and measurement results have shown that increasing conductivity is not desired for applications of covers on circuitry that is contained within other packaging enclosures.

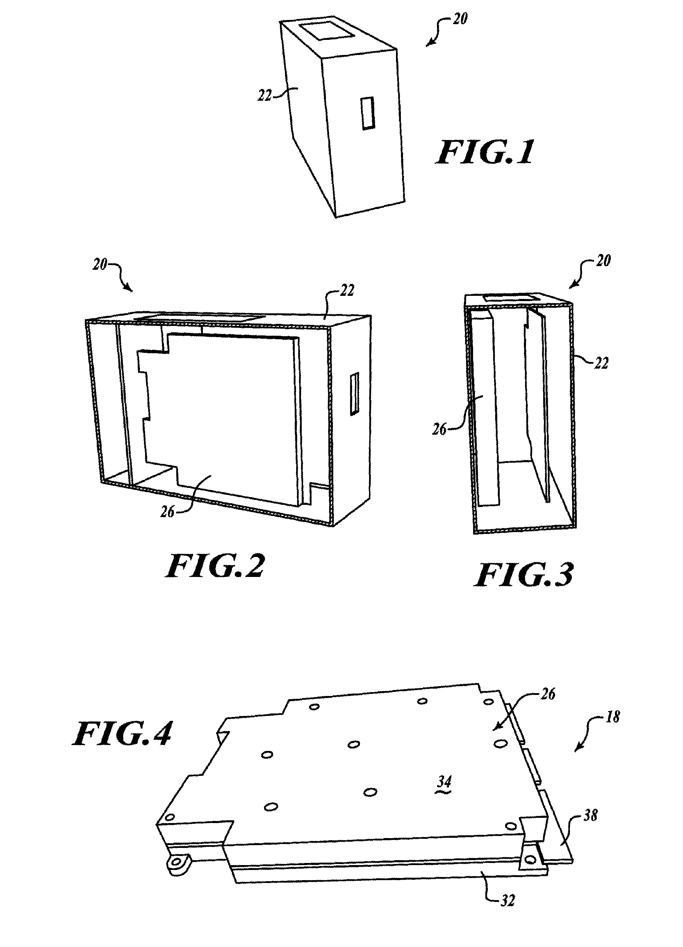

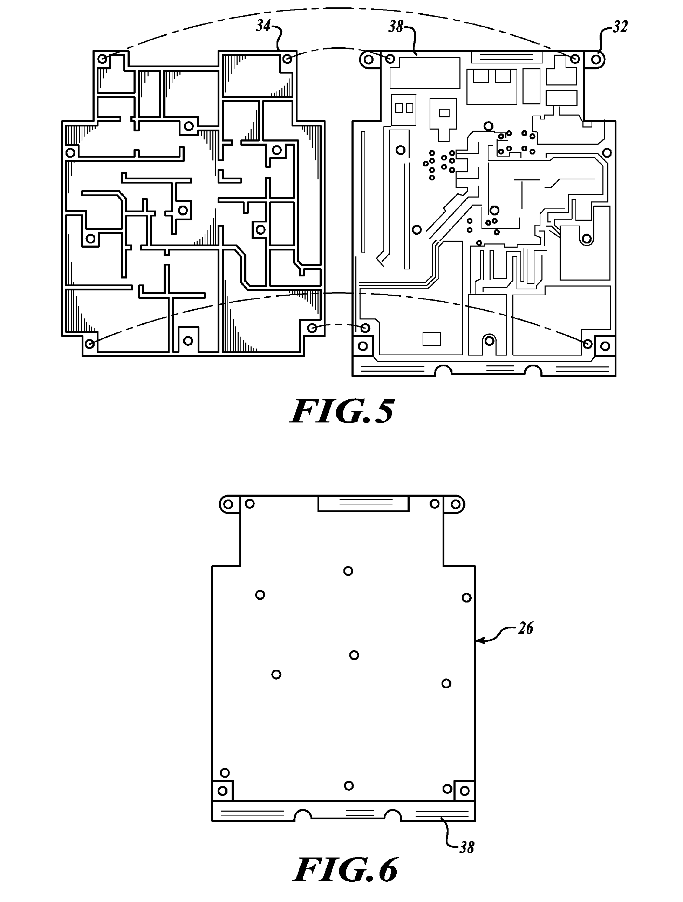

FIGURES 1-3 illustrate various perspective views of an electronics box 20 that is used to house one or more circuit boards. In one embodiment of the present invention, one or more of the circuit boards is located within the electronics box 20 inside a circuit board assembly 26. The circuit board assembly 26 includes a circuit board and one or more covers that surround the circuit board. FIGURES 4-6 illustrate various views of the circuit board assembly 26. The circuit board assembly 26 includes a circuit board 38 that is sandwiched between a top cover 34 and a bottom cover 32. Each of the covers 32 and 34 include various segmented cavities on the side of the cover that faces the circuit board 38. The formed cavities and compartments on the side of the covers 32 and 34 that face the circuit board 38 are formed depending upon the circuit components located on the respective face of the circuit board 38.

In one aspect of the invention, it is assumed that the lossy composite covers placed over a circuit board 38 will be placed inside of another overall chassis structure. This outer chassis structure 22 as shown in FIGURE 2, is required to reflect any residual electromagnetic energy that may initially pass through the lossy cover 26 back into the lossy cover 26. Electromagnetic simulations have demonstrated that it is this repeated reabsorption by the cover within the overall chassis structure 22 that reduces radiated emissions from a complex electronics chassis below that of a chassis containing all metal shielding.

Therefore, should it be desired to use the present invention concept on an electronic circuit board, connector cover or other application where the lossy composite cover would be the sole means to provide electromagnetic shielding, the outer section of the lossy composite cover should be coated with a conductive metal layer using "flame spray" (commercial term for plasma plating) or other commercial means. This outer conductive layer provides the means to reflect escaping energy that has passed through the lossy cover back into the lossy material for further attenuation. This outer metal coating is only required when the lossy composite cover is not used within another chassis. When the lossy cover is placed within another structure that is either metal, composite, plastic etc, it must not be coated with metal.

The covers 32 and 34 are molded from composite materials which include a base resin. The composite covers 32, 34 are lossy for preventing the occurrence of resonances and oscillations in covered circuits. The lossy composite covers 32, 34 provide continuous absorption of energy reflected within an outer chassis 22 to achieve an improvement in internal and external levels of radiated emissions. The lossy composite covers 32, 34 provide improved protection against incident emissions. The composite covers 32, 34 with high conductivity exterior coating of metal can be used to provide a single layer of lossy EMI shielding without an external chassis. Various materials can be combined within the covers to achieve different levels of conductivity, strength and weight.

Additives to the base resin may be any one of the materials or combination of materials below:
Carbon fiber;
Carbon Nanofiber;
Carbon Nanotubes;
Carbon Micropheres;
Graphite Flakes;
Graphene Sheets;
Nickel Coated Carbon Fiber;
Nickel Coated Carbon Micropheres;
Nickel Coated Graphite Particles
Nickel Coated Carbon Nanofiber, and
Nickel Nanostrands.

The Carbon fibers may be chopped or milled.

In one embodiment, the base resin is polyetherimide (PEI) that is combined with one or more of the composite materials above. PEI is an amorphous, amber transparent, high-performance thermoplastic that provides high heat resistance, high strength and modulus, and excellent electrical insulating properties. PEI performs continuously to 340°F (170°C), is ideal for high strength/high heat applications and is hydrolysis resistant, highly resistant to acidic solutions and capable of withstanding repeated autoclaving cycles. PEI grades are available in an electrostatic dissipative grade, and FDA, & USDA compliant grades. Common trade names for PEI include Ultem®, Tecapei®, and Tempolux®.

Polyethersulfone (PES) (e.g., Ultrason® (BASF)) may be used instead of PEI. PES is also high temperature resistant (180°C continuous) with good mechanical performance at high temperatures.

Polyphenylene sulfide (PPS) (e.g. Ryton®) is a highly crystalline (50-60% crystallinity) thermoplastic. PPS is fire resistant, impervious to aircraft fluids, and has a low viscosity which facilitates processing. Its mechanical properties and temperature tolerance do not match PEI.

Pellets for injection molding a cover were made by mixing 20 wt% chopped carbon fiber (Fortafil 219), 10 wt% nickel coated carbon fiber (Sulzer NiCF) and 70 wt% polyetherimide (Ultem 1000). This material had an electrical resistivity of 3.7 ohm-cm and a density of 1.37 g/cc. Tensile properties (ASTM D-638-03) at room temperature were 28,000 psi tensile strength, 1,200,000 psi modulus, and 1.2% elongation. The corresponding flexural properties (ASTM D-790-07) were 35,000 psi flexural strength, and 3,000,000 psi flexural modulus. Other percentage mixtures may be used.

In one embodiment, the present invention uses PEI, PES or closely related resins such as Polyphenylenesulfide (PPS) that meet FAA FST and strength requirements. Injection or compression molding is used to form the covers into 3D complex covers or slightly contoured panels, respectively.

The covers formed from the material described above may also include, at a minimum, carbon fiber or nanofiber strands to provide basic conductivity and improved strength over the neat matrix resin. Nickel fiber or nickel powder may be added to any combination to achieve higher conductivity and provide magnetic shielding. Desired conductivity with lowest weight may also be achieved by using high levels of carbon fiber when the cost and weight of nickel is not desired.

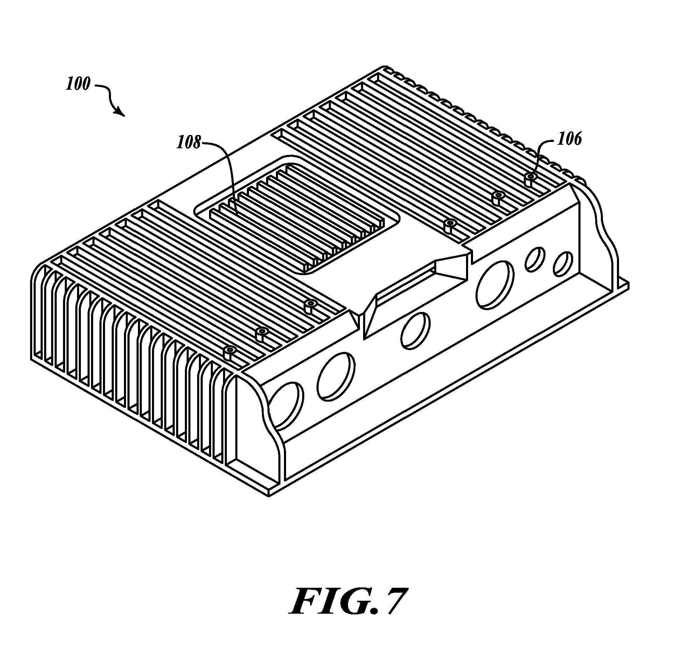

As shown in FIGURE 7, threaded inserts 106 and heat sinks 108 are added in appropriate (predefined) locations of a cover 100 to provide mechanical attachments and heat dissipation for thermally stressed components. The heat sinks 108 may be added at the time of molding or the composite may be machined and the parts added post molding.
The embodiments of the invention in which an exclusive property or privilege is claimed are defined as follows:

## Claims

1. A circuit board cover (32,34) enclosed within a metal chassis (22), the circuit board cover made from materials consisting of:
a carbon-based material; and
a polymeric resin.

2. The cover of Claim 1, wherein resistivity of the cover is between 0.5 and 10 ohm-cm.

3. The cover of Claim 1, wherein the cover further comprises at least one molded heat sink (108) and/or one or more molded threaded inserts (106).

4. The cover of Claim 1, wherein the polymeric resin comprises a thermoplastic, and at least one of polyetherimide, polyphenylene sulfide, or polyethersulfone, wherein the cover complies with predefined flammability, smoke density and toxicity requirements.

5. The cover of Claim 1, wherein the carbon-based material comprises a combination of at least two of carbon fibers, carbon nanofibers, carbon microspheres, carbon nanotubes, graphite flakes, graphene sheets, nickel nanostrands, and nickel coated carbon fibers, graphene particles, or nanofibers.

6. A circuit board cover (32,34) for use in a nonreflecting electromagnetic environment, the circuit board cover made from materials consisting of:
a carbon-based material,
a polymeric resin, and
a conductive metallic coating on one side of the cover.

7. The cover of Claim 6, wherein the cover further comprises at least one molded heat sink (108) and/or one or more molded threaded inserts (106).

8. The cover of Claim 6, wherein the carbon-based material comprises a combination of at least two of carbon fibers, carbon nanofibers, carbon microspheres, carbon nanotubes, graphite flakes, graphene sheets, nickel nanostrands , and nickel coated carbon fibers, graphene particles, and nanofibers.

9. The cover of Claim 6, wherein the cover complies with predefined flammability, smoke density and toxicity requirements.

10. The cover of Claim 6, wherein the carbon-based material comprises a combination of at least two of carbon fibers, carbon nanofibers, carbon nanotubes, or carbon microspheres.
